# FASCICULE DE BREVET EUROPEEN

(11) **EP 2 962 337 B1**
(45) Date de publication et mention de la délivrance du brevet: **09.12.2020**
(21) Numéro de dépôt: 14713168.4
(22) Date de dépôt: 21.02.2014
(51) Int. Cl.: H01L 43/08, H01L 43/12, H01F 41/30

(54) **PROCÉDÉ DE TRAITEMENT D'UNE STRUCTURE MAGNÉTIQUE**
VERFAHREN ZUR BEHANDLUNG EINER MAGNETISCHEN STRUKTUR
PROCESS FOR TREATING A MAGNETIC STRUCTURE

(30) Priorité: 27.02.2013 FR 1351739
(43) Date de publication de la demande: 06.01.2016
(73) Titulaire: Centre National de la Recherche Scientifique (C.N.R.S.), 75794 Paris Cedex 16 (FR); Université Paris-Saclay, 91190 Saint-Aubin (FR)
(72) Inventeur: RAVELOSONA, Dafiné, F-91190 Villiers Le Bacle (FR)
(74) Mandataire: Lavoix
(86) Numéro de dépôt international: PCT/FR2014/050366
(87) Numéro de publication internationale: WO 2014/131969

(56) Documents cités:
- CN-A- 101 345 286
- US-A1- 2011 096 443
- US-A1- 2012 244 640
- KRAPOSHIN ET AL: "Crystallization of Co-based amorphous alloys under the impact of the ion irradiation and recovery of the amorphous phase", JOURNAL OF NON-CRYSTALLINE SOLIDS, NORTH-HOLLAND PHYSICS PUBLISHING. AMSTERDAM, NL, vol. 353, no. 32-40, 15 septembre 2007 (2007-09-15), pages 3057-3061, XP022251599, ISSN: 0022-3093, DOI: 10.1016/J.JNONCRYSOL.2007.05.038

## Description

La présente invention concerne un procédé de traitement d'une structure magnétique, notamment destinée à l'enregistrement numérique pour être utilisée par exemple dans une mémoire MRAM (Magnetic Random Access Memory).

Face à l'augmentation considérable du volume global de données numériques générées dans le monde (2,7 zettabits en 2012), il est indispensable que la densité de stockage (capacité de stockage par unité de surface) des mémoires de masse non volatiles continue de s'accroître. Cette croissance doit permettre d'endiguer une multiplication des supports de stockage, de répondre aux exigences de compacité des applications mobiles et de réduire l'empreinte énergétique.

Le marché des mémoires de masse non volatiles est aujourd'hui partagé entre les disques durs (ordinateurs et « data centers ») et les mémoires flash pour les applications mobiles (smartphones, ultra portables, etc.). Bien que les performances de ces deux technologies aient considérablement progressé ces dernières années, elles vont rencontrer des verrous technologiques majeurs à l'horizon 2015 en termes de compacité autant que de rapidité d'accès et de stabilité au cours du temps.

De nouveaux concepts de mémoires solides non volatiles MRAM (STT-MRAM, « Race Track Memory », TAS-MRAM, etc...), concurrentes des mémoires flash mais aussi des mémoires DRAM et SRAM, sont donc en cours de développement.

Cependant ces nouvelles technologies sont freinées par des verrous technologiques liés en particulier aux matériaux magnétiques utilisés.

En effet, ces mémoires sont basées sur des matériaux magnétiques qui sont synthétisés à température ambiante sous forme amorphe puis recuits à haute température (300°C pendant 1 à 2 heures) pour obtenir une phase cristalline qui possède les propriétés requises, en particulier une anisotropie magnétique élevée et un fort signal de magnéto résistance.

Cependant, ces températures élevées peuvent dégrader les propriétés des matériaux, qui obtenus après recuit thermique présenteront généralement plus de défauts structuraux responsables d'une plus forte hétérogénéité des propriétés magnétiques.

De plus ces températures élevées engendrent des dépenses énergétiques importantes difficilement compatibles avec l'industrialisation des procédés. Il est connu d'irradier des couches en CoFe par des ions de Ga, voir CN 101345286 A. Des autres exemples de l'art antérieur sont donnés par US 2012 / 0244640 A1, US 2011 / 0096443 A1 et par V.S. Kraposhin et al., "Crystallization of Co-based amorphous alloys under the impact of the ion irradiation and recovery of the amorphous phase", Journal of Non-Crystalline Solids, vol. 353, p. 3057-3061, (2007).

La présente invention a pour but de pallier ces inconvénients en proposant un procédé qui permette d'obtenir des matériaux magnétiques de meilleure qualité tout en rendant leur fabrication industrialisable.

A cet effet, l'invention a pour objet un procédé tel que défini par la revendication 1.

Grâce au couplage chauffage/irradiation ionique, les températures et durées de synthèse des matériaux magnétiques peuvent être fortement diminuées, réduisant le budget thermique et améliorant la qualité des matériaux ainsi obtenus.

Des autres modes de réalisation sont définis par les revendications dépendantes.

L'invention a également pour objet une structure telle que définie par la revendication 13.

En particulier, la structure magnétique peut posséder un champ d'anisotropie effectif supérieur ou égal à 500 mT.

L'invention sera mieux comprise à la lecture de la description qui va suivre de différents modes de réalisation de l'invention, donnés uniquement à titre d'exemple en se référant aux dessins annexés, sur lesquels :
- la Figure 1 est un schéma représentant les différentes étapes d'un procédé de traitement d'une structure magnétique selon l'invention ;
- la Figure 2 est une vue en coupe d'une structure magnétique selon l'invention ;
- les Figures 3, 4 et 5 sont des vues en coupe illustrant des variantes de la structure magnétique de la Figure 2 ;
- les Figures 6, 7, 8, 9 et 10 sont des vues similaires à celle de la Figure 2 illustrant différents modes de réalisation du procédé de traitement de la Figure 1.

Sur les différentes Figures, les mêmes références désignent des éléments identiques ou similaires.

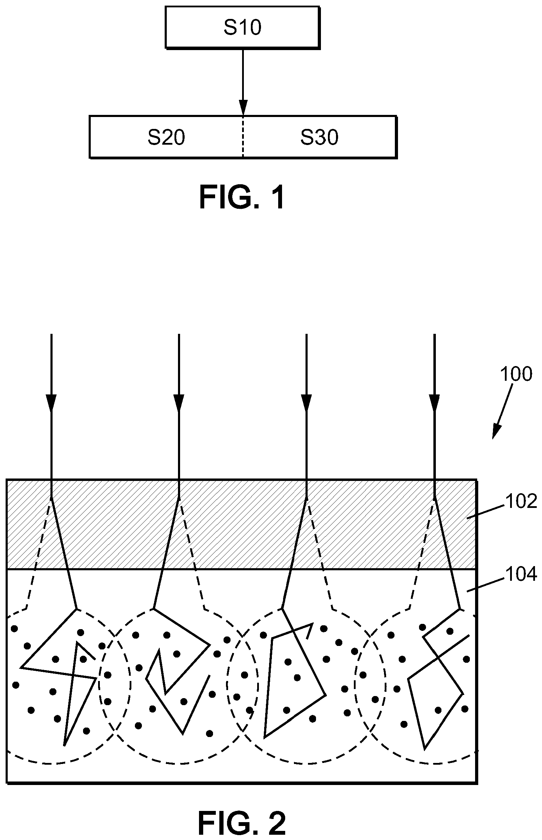

La Figure 1 illustre les différentes étapes d'un procédé de traitement d'une structure magnétique selon l'invention.

Une première étape S10 de ce procédé comprend la fourniture d'une structure magnétique 100.

En référence à la Figure 2, la structure magnétique 100 comporte une première couche 102 fabriquée à partir d'un matériau magnétique comprenant un alliage de CoFeB.

La structure magnétique 100 comporte en outre un substrat 104 sur lequel est agencée la couche magnétique 102.

La structure magnétique 100 peut également comprendre une couche dite « buffer » 101 telle qu'une couche de Ta déposée entre le substrat 104 et l'empilement magnétique 102 et permettant de promouvoir une structure cristalline spécifique pour la couche magnétique et une anisotropie d'interface.

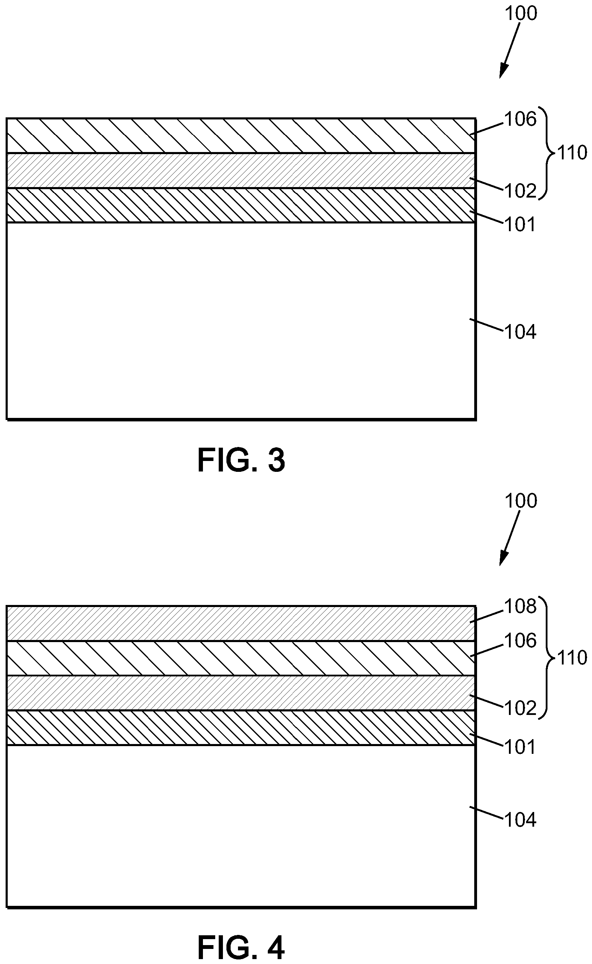

Dans une première variante illustrée sur la Figure 3, la structure magnétique 100 est une structure multicouches comprenant, en plus de la couche magnétique 102 déposée sur la couche buffer 101, une deuxième couche 106 fabriquée à partir d'un matériau isolant et déposée sur la couche magnétique 102.

Dans une deuxième variante illustrée sur la Figure 4, la structure magnétique 100 est une structure multicouches comprenant, en plus de la couche magnétique 102 déposée sur la couche buffer 101 et de la couche d'isolant 106, une troisième couche 108 fabriquée à partir d'un matériau magnétique comprenant un alliage de CoFeB et déposée sur la couche d'isolant.

Les couches magnétiques 102 et 108 sont identiques l'une à l'autre. En variante, les couches magnétiques 102 et 108 peuvent être différentes l'une de l'autre. On notera de façon générale par la suite les différentes couches magnétiques contenant l'alliage CoFeB, les couches « de type 102 ».

La couche d'isolant 106 comprend du MgO. En variante, la couche d'isolant 106 peut avoir une composition différente. De façon générale, on notera couche « de type 106 » une couche d'isolant incluse dans un empilement magnétique quelle que soit sa composition.

La couche buffer 101 étant optionnelle, nous ne la représenterons plus dans la suite par souci de simplification des Figures.

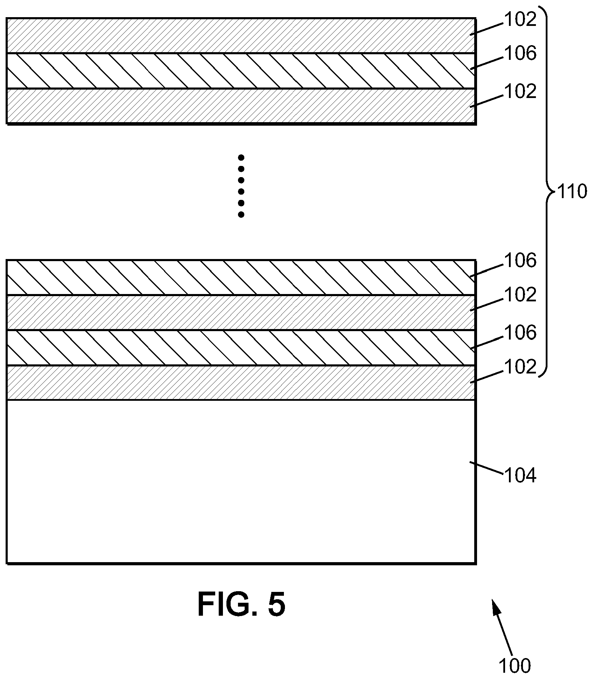

Dans une troisième variante illustrée sur la Figure 5, la structure magnétique 100 est une structure multicouches comprenant une succession alternée de couches de type 102 et de couches de type 106, cet empilement de couches étant déposé directement sur le substrat 104. On notera l'empilement de couches magnétiques et isolantes 110.

Notons que les couches de type 102 peuvent elles-mêmes comprendre un empilement de couches magnétiques comportant des couches d'alliage de CoFeB combinées avec des couches d'autres matériaux magnétiques.

De plus, la structure magnétique 100 peut également être recouverte par une couche appelée « capping layer » pour limiter l'oxydation de la structure magnétique.

Les couches magnétiques de type 102 et isolantes de type 106 décrites dans tout ce qui précède s'étendent sensiblement parallèlement les unes aux autres.

Les couches magnétiques de type 102 présentent une épaisseur comprise entre 0,1 nm et 3 nm.

L'alliage de CoFeB contenu dans les couches magnétiques de type 102 comprend par exemple environ 20% de cobalt, 60% de fer et 20% de bore. En variante, l'alliage de CoFeB contenu dans les couches magnétiques de type 102 peut comprendre par exemple environ 40% de cobalt, 40% de fer et 20% de bore. En variante encore, l'alliage de CoFeB peut comprendre par exemple environ 60% de cobalt, 20% de fer et 20% de bore.

Les couches isolantes de type 106 présentent une épaisseur comprise entre 0,1 nm et 3 nm.

Le substrat 104 présente une épaisseur de plusieurs centaines de micromètres.

Le substrat 104 peut être un substrat quelconque comprenant par exemple du SiO₂, du SIN ou un wafer CMOS.

L'étape de fourniture S10 est suivie d'une étape d'irradiation S20 de la structure magnétique 100 et d'une étape S30 de chauffage de la structure magnétique 100 (Figure 1).

Les étapes d'irradiation S20 et de chauffage S30 sont réalisées simultanément.

L'étape d'irradiation S20 comprend l'irradiation de la structure magnétique 100 par des ions légers de faible énergie et de faible courant.

Lors de cette étape d'irradiation ionique S20, les ions sont émis sous forme d'un faisceau d'ions qui baigne uniformément la structure magnétique 100 (Figure 2).

Les ions sont également émis avec une faible dose comprise entre 1^{∗}10¹³ ions/cm² et 5^{∗}10¹⁶ ions/cm² et avec un faible courant inférieur à 10 µA pour ne pas chauffer la structure magnétique 100.

Les ions émis traversent alors l'empilement magnétique 110 et s'implantent en profondeur dans le substrat 104, par exemple à une profondeur du substrat comprise entre 100 nm et 300 nm. Les ions émis ne sont pas utilisés pour un traitement de surface de l'empilement. Les ions émis ne sont pas non plus implantés dans les couches magnétiques irradiées comme c'est le cas en traitant des empilements magnétiques épais. Selon l'invention, les ions émis traversent les couches magnétiques de l'empilement où ils modifient localement la structure en créant des déplacements inter-atomiques et viennent s'implanter en profondeur dans le substrat 104 sur lequel a été déposé l'empilement de couches.

Les ions utilisés pour l'irradiation ont une énergie comprise entre 0,1 keV et 150 keV.

Dans l'exemple décrit ici, les ions sont des ions He⁺.

En variante, les ions sont des ions H⁺ ou des ions Ar⁺, Xe⁺, Ga⁺.

L'étape d'irradiation ionique S20 ne conduit donc pas à un ajout de matière dans les couches magnétiques, contrairement à ce qui se passe dans des procédés d'implantation ionique couramment utilisés dans l'industrie des semi-conducteurs.

A la place, l'étape d'irradiation ionique S20 engendre des modifications structurales des couches irradiées. Les propriétés magnétiques des matériaux étant liées à leur structure atomique, l'irradiation ionique permet donc de contrôler les propriétés magnétiques des matériaux de manière très fine.

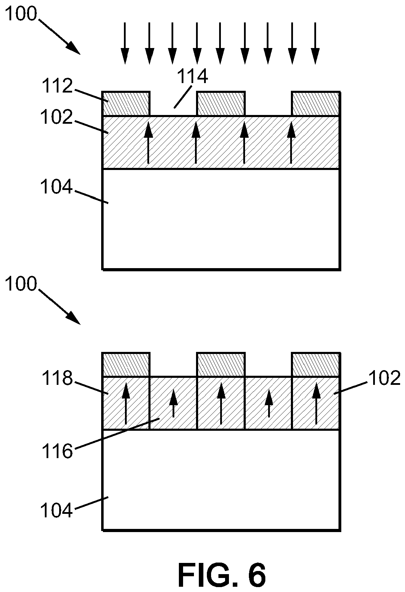

L'étape d'irradiation S20 peut être réalisée au travers d'un masque 112 dans lequel sont ménagées des ouvertures traversantes 114 comme illustré à la Figure 6.

Simultanément à l'étape d'irradiation ionique S20, la structure magnétique 100 est maintenue selon un profil de température prédéterminé et pendant un temps prédéterminé.

La température prédéterminée est inférieure ou égale à 200°C, de préférence inférieure ou égale à 100°C.

Le temps prédéterminé est inférieur ou égal à 1 heure, de préférence inférieur ou égal à 30 min, et de préférence encore inférieur ou égal à 10 min.

L'étape de chauffage S30 combinée à l'étape d'irradiation permet de favoriser la relaxation du matériau vers un état d'équilibre homogène en favorisant la mobilité des atomes.

Différents modes de réalisation du procédé de traitement selon l'invention sont décrits ci-dessous dans le cas d'une structure magnétique 100 comprenant une couche magnétique 102 comme décrit à la Figure 2. La direction d'aimantation de la couche magnétique est symbolisée par une flèche.

Dans un premier mode de réalisation du procédé de traitement selon l'invention, le procédé permet de faire varier, en particulier de diminuer, l'amplitude de l'anisotropie de la couche magnétique 102.

L'anisotropie d'une couche magnétique est une grandeur qui définit et quantifie les directions privilégiées de l'aimantation dans la couche magnétique.

Dans les matériaux basés sur des multicouches magnétiques ultra-fines, les propriétés sont dominées par la compétition entre des effets d'interfaces et des propriétés de volume. Par exemple, la direction d'aimantation est donnée par le signe d'un coefficient d'anisotropie K_{eff}, qui est donné en première approximation dans le CoFeB par K_{eff}=-K_{d}+(K_{S1}+K_{S2})/t_{CoFeB}. Le premier terme K_{d} représente l'anisotropie dipolaire de forme (K_{d} positif), le second terme K_{S1}+K_{S2} représente l'influence des interfaces (K_{S1} et K_{S2} représentent les coefficients d'anisotropie aux deux interfaces du film de CoFeB). Ce dernier terme K_{S1}+K_{S2} est inversement proportionnel à l'épaisseur t_{COFEB} du CoFeB. En fonction du signe du coefficient d'anisotropie K_{eff}, l'axe de facile aimantation du film peut être perpendiculaire au plan du film (K_{eff} positif) ou dans le plan du film (K_{eff} négatif). On définit le champ d'anisotropie effectif H_{eff}=2K_{eff}/Mₛ où Mₛ est l'aimantation du film. Ce champ peut être mesuré en appliquant un champ magnétique suivant l'axe difficile de l'aimantation ou suivant un axe intermédiaire.

Dans ce premier mode de réalisation, la couche magnétique 102 est initialement cristalline et présente une anisotropie magnétique perpendiculaire (aimantation perpendiculaire au plan des couches) forte. Par exemple, le champ d'anisotropie effectif est compris entre 300 mT et 400 mT.

La structure magnétique 100 est alors irradiée par des ions légers de faible énergie et avec une température ambiante comprise entre 15°C et 40°C.

La couche magnétique 102 reste cristalline mais son anisotropie magnétique perpendiculaire diminue. Par exemple, le champ d'anisotropie effectif est compris entre 0 et 300 mT.

Comme représenté sur la Figure 6, l'étape d'irradiation S20 peut également être réalisée au travers du masque 112. On obtient alors une structure magnétique 100 à anisotropie mixte, c'est-à-dire avec des portions 116 à aimantation plus faiblement perpendiculaire correspondant aux portions de la structure situées en regard des ouvertures 114 du masque 112, et avec des portions 118 à aimantation fortement perpendiculaire correspondant aux autres portions de la structure.

Dans un deuxième mode de réalisation, la couche magnétique 102 est initialement cristalline et présente une forte anisotropie magnétique perpendiculaire. Par exemple, le champ d'anisotropie effectif est compris entre 300 mT et 400 mT.

La structure magnétique 100 est alors irradiée par des ions légers de faible énergie et avec une température ambiante comprise entre 15°C et 40°C, de sorte que la couche magnétique 102 reste cristalline mais devient alors aimantée dans le plan (aimantation dans le plan des couches) avec une amplitude pour le champ d'anisotropie effectif par exemple comprise entre 0 et -200 mT.

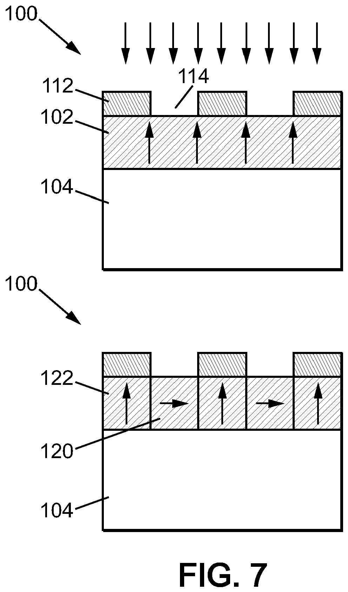

En réalisant l'étape d'irradiation S20 au travers du masque 112 comme représenté sur la Figure 7, il est également possible d'obtenir une structure magnétique 100 à anisotropie mixte, c'est-à-dire avec des portions 120 à aimantation planaire correspondant aux portions de la structure situées en regard des ouvertures 114 du masque 112, et avec des portions 122 à aimantation fortement perpendiculaire correspondant aux autres portions de la structure.

Dans un troisième mode de réalisation, la couche magnétique 102 initialement cristalline ou amorphe présente une faible anisotropie magnétique perpendiculaire. Par exemple, le champ d'anisotropie effectif est compris entre 0 et 100 mT.

La structure magnétique 100 est alors irradiée par des ions légers de faible énergie et chauffée simultanément à une température supérieure à la température ambiante, au moins supérieure à 20°C, par exemple supérieure à 50°C.

La couche magnétique 102 reste cristalline si initialement cristalline ou devient cristalline si initialement amorphe, et l'anisotropie perpendiculaire de cette couche magnétique augmente. Par exemple, le champ d'anisotropie effectif est compris entre 100 mT et 600 mT.

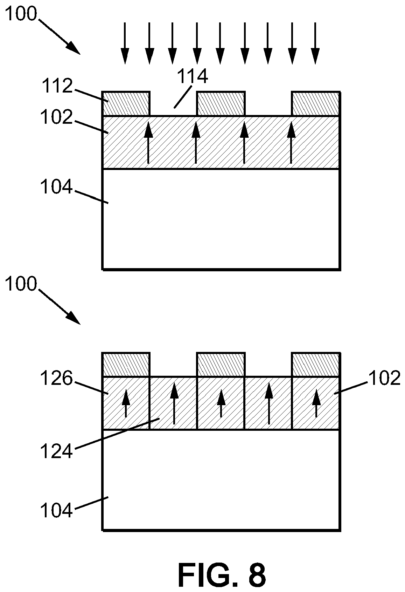

En réalisant l'étape d'irradiation S20 au travers du masque 112 comme représenté sur la Figure 8, il est possible d'obtenir une structure magnétique 100 à anisotropie mixte, c'est-à-dire avec des portions 124 à forte aimantation perpendiculaire correspondant aux portions de la structure situées en regard des ouvertures 114 du masque 112, et avec des portions 126 à faible aimantation perpendiculaire correspondant aux autres portions de la structure.

Une anisotropie perpendiculaire d'amplitude élevée est favorable à une forte stabilité thermique par exemple pour les applications d'ultra haute densité. En appliquant les étapes combinées S20 et S30 comme décrites précédemment, on obtient une aimantation perpendiculaire d'amplitude plus élevée qu'en traitant le matériau par un recuit thermique à hautes températures comme il est réalisé aujourd'hui.

Dans un quatrième mode de réalisation, la couche magnétique 102 initialement amorphe présente un champ d'anisotropie effectif planaire avec une amplitude par exemple comprise entre 0 et -200 mT.

La structure magnétique 100 est alors irradiée par des ions légers de faible énergie et chauffée simultanément à une température supérieure à la température ambiante, au moins supérieure à 20°C, par exemple supérieure à 50°C.

La couche magnétique 102 initialement amorphe devient cristalline et l'anisotropie de la couche magnétique devient fortement perpendiculaire avec une amplitude par exemple comprise entre 0 et 600 mT.

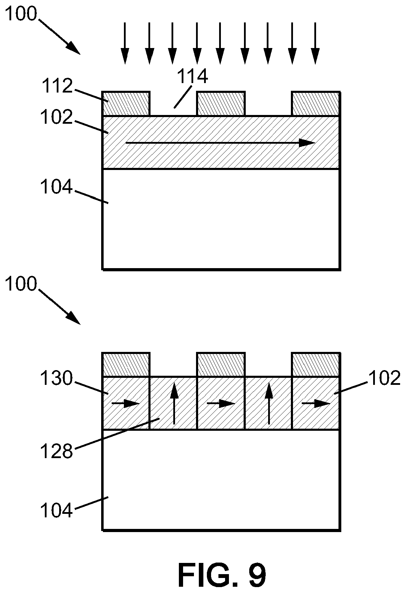

En réalisant cette étape d'irradiation S20 au travers du masque 112 comme représenté sur la Figure 9, il est possible d'obtenir une structure magnétique 100 à anisotropie mixte, c'est-à-dire avec des portions 128 à aimantation fortement perpendiculaire correspondant aux portions de la structure situées en regard des ouvertures 114 du masque 112, et avec des portions 130 à aimantation planaire correspondant aux autres portions de la structure.

Dans un cinquième mode de réalisation, la couche magnétique 102 est initialement cristalline et présente une forte anisotropie magnétique perpendiculaire. Par exemple, le champ d'anisotropie effectif est compris entre 300 mT et 400 mT.

La structure magnétique 100 est alors irradiée par des ions légers de faible énergie et avec une température ambiante comprise entre 15°C et 40°C, de sorte que la couche magnétique est complétement mélangée avec les couches adjacentes et devient alors non magnétique.

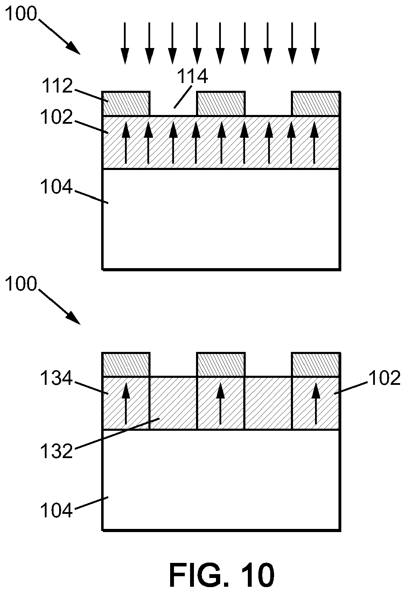

En réalisant cette étape d'irradiation S20 au travers du masque 112 comme représenté sur la Figure 10, il est possible d'obtenir une structure magnétique 100 à anisotropie mixte, c'est-à-dire avec des portions 132 non magnétiques correspondants aux portions de la structure situées en regard des ouvertures 114 du masque 112, et avec des portions 134 à aimantation fortement perpendiculaire correspondant aux autres portions de la structure.

La couche magnétique 102 initialement cristalline décrite dans les premier et deuxième modes de réalisation du procédé selon l'invention peut être celle obtenue après traitement par le procédé selon les troisième et quatrième modes de réalisation de l'invention décrits ci-dessus, ou par recuit thermique avec une température supérieure ou égale à 300°C pendant 1 à 2 heures.

Il est ainsi possible en utilisant un masque lors de l'irradiation d'obtenir différents motifs de structures magnétiques au sein de la couche magnétique 102, à l'aide de différents masques qui diffèrent les uns des autres par le nombre, la forme, les dimensions et positions des ouvertures 114. On peut ainsi atteindre des dimensions latérales de motifs nanométriques difficilement accessibles via les techniques de nanostructuration classiques (litographie etc...).

L'utilisation de masques permet la réalisation de nanostructures enfouies dans des couches continues, correspondant à des variations locales des propriétés magnétiques. Une application possible de ce type de structure serait la génération et le piégeage de parois magnétiques dans de telles structures.

Bien que les modes de réalisations illustrés dans le cas de l'utilisation d'un masque d'irradiation aux Figures 6 à 10 soient décrits en utilisant une structure magnétique 100 comprenant une seule couche magnétique de type 102, ces modes de réalisation sont applicables aux variantes de la structure magnétique 100 décrites aux Figures 3 à 5.

Le procédé selon l'invention repose donc sur l'utilisation post-dépôt de l'irradiation ionique pour traiter des films de CoFeB-isolant et en particulier pour améliorer leurs propriétés structurales et contrôler leurs propriétés magnétiques. Il est aussi possible d'obtenir des propriétés magnétiques alternées à travers le film via l'utilisation d'un masque.

L'irradiation de matériaux magnétiques par des ions légers présente les caractéristiques suivantes :
- faible transfert d'énergie entre les ions incidents et les atomes du matériau permettant un contrôle optimal des propriétés magnétiques ;
- absence de cascade de collisions minimisant la création de défaut dans le matériau ;
- conservation de la microstructure et de la cristallinité des matériaux irradiés si l'on part d'un matériau cristallin; et
- conservation de l'état de surface.

En outre, il est possible d'obtenir une phase cristalline à partir d'une phase amorphe à de faibles températures (inférieures à 200°C) et pour des temps de recuit très inférieurs à 1 heure en couplant le chauffage à l'irradiation par des ions légers de faible énergie, ce qui diminue fortement la consommation énergétique nécessaire à la production de ces matériaux.

De plus il est possible d'obtenir ainsi un matériau magnétique avec une anisotropie magnétique perpendiculaire entre 50% et 100% plus élevée, notamment supérieure ou égale à 500 mT, que par un recuit thermique à 300°C où le champ d'anisotropie effectif est compris entre 300 mT et 400 mT. L'anisotropie magnétique perpendiculaire ainsi obtenue peut être notamment supérieure ou égale à 600 mT.

Dans les troisième et quatrième modes de réalisation illustrés aux Figures 8 et 9, les structures magnétiques issues des étapes simultanées d'irradiation et de chauffage ont une forte anisotropie perpendiculaire. De telles structures sont industriellement très recherchées. En effet l'utilisation de matériaux magnétiques à anisotropie perpendiculaire permettrait d'obtenir des largeurs de parois magnétiques au sein des matériaux plus faibles dans la perspective de réduire les dimensions des nanostructures, et permettrait potentiellement d'améliorer les performances, réduire les paramètres critiques tels que le courant de transfert de spin nécessaire à appliquer pour déplacer une paroi magnétique dans une nanostructure magnétique intégrée dans une mémoire magnétique.

On peut alors envisager d'utiliser dans l'industrie des films de CoFeB plus épais (jusqu'à 2 nm au lieu d'épaisseurs entre 1,2 nm et 1,5 nm auxquels on est habituellement limité) conservant leur anisotropie magnétique perpendiculaire, et donnant des valeurs de signal de magnétorésistance plus élevées, une avancée cruciale de nos jours.

Les principaux domaines d'application envisagés concernent les mémoires magnétiques MRAM ainsi que la fabrication des têtes de lecture des disques durs.

L'invention peut s'appliquer à des structures multicouches dans lesquelles les couches sont continues ou nanostructurées.

## Revendications

1. Procédé de traitement d'une structure magnétique (100), **caractérisé en ce qu'**il comprend les étapes suivantes :
- fourniture (S10) d'une structure magnétique (100) comprenant au moins une première couche (102) de matériau magnétique comprenant un alliage de CoFeB, ledit matériau magnétique étant déposé sur un substrat (104) ;
- irradiation (S20) de la structure magnétique (100) par des ions légers de faible énergie choisis parmi He+, H+, Ar+, Xe+ ou Ga+, de façon à ce que les ions émis lors de l'étape d'irradiation traversent ladite au moins une première couche (102) de matériau magnétique et viennent s'implanter en profondeur dans le substrat (104) à une profondeur du substrat-comprise entre 100 nm et 300 nm et ladite irradiation (S20) engendre des modifications structurales des couches magnétiques irradiées; et
- maintien (S30) simultané de la structure magnétique (100) selon un profil de température prédéterminé et pendant un temps prédéterminé.

2. Procédé selon la revendication 1, dans lequel la structure magnétique (100) comprend au moins une deuxième couche (106) d'isolant en contact avec la première couche (102) de matériau magnétique de façon à former un empilement (110) de couches (102, 106, 108) déposé directement sur le substrat (104), les ions émis lors de l'étape d'irradiation (S20) traversant un masque (112) et 'empilement et modifiant localement la structure dans les couches magnétiques en créant des déplacements inter-atomiques, jusqu'à s'implanter en profondeur dans le substrat (104) sur lequel a été déposé ledit empilement (110) de couches.

3. Procédé selon la revendication 1 ou 2, dans lequel la température prédéterminée est comprise entre 20°C et 200°C.

4. Procédé selon la revendication 1 ou 2, dans lequel la température prédéterminée est comprise entre 15°C et 40°C.

5. Procédé selon l'une quelconque des revendications 1 à 4, dans lequel le temps prédéterminé est inférieur ou égal à 1 heure.

6. Procédé selon l'une quelconque des revendications 1 à 5, dans lequel le matériau magnétique est initialement amorphe.

7. Procédé selon l'une quelconque des revendications 1 à 5, dans lequel le matériau magnétique est initialement cristallin.

8. Procédé selon l'une quelconque des revendications 1 à 7, dans lequel les ions sont des ions He⁺.

9. Procédé selon l'une quelconque des revendications 1 à 8, dans lequel les ions présentent une énergie comprise entre 0,1 keV et 150 keV.

10. Procédé selon l'une quelconque des revendications 1 à 9, dans lequel, lors de l'étape d'irradiation (S20), les ions sont émis avec une dose comprise entre 1^{∗}10¹³ ions/cm² et 5^{∗}10¹⁶ ions/cm².

11. Procédé selon l'une quelconque des revendications 1 à 10 dans lequel, lors de l'étape d'irradiation (S20), les ions bombardent la structure magnétique (100) à travers des ouvertures traversantes (114) d'un masque (112).

12. Procédé selon l'une quelconque des revendications 1 à 11, dans lequel la structure magnétique (100) comprend un empilement alterné de premières couches (102) de matériau magnétique et de deuxièmes couches (106) d'isolant.

13. Structure magnétique (100), comprenant au moins :
- une première couche (102) de matériau magnétique comprenant un alliage de CoFeB ; et
- un substrat (104) sur lequel est agencée la première couche (102) de matériau magnétique ;
**caractérisée en ce qu'**elle comprend une superposition directe entre le substrat (104) et la première couche (102), résultant d'un dépôt direct dudit matériau magnétique sur le substrat (104),
et **en ce que** le substrat (104) comprend des atomes légers de faible énergie, implantés dans le substrat (104) à une profondeur comprise entre 100 nm et 300 nm.

14. Structure magnétique selon la revendication 13, possédant un champ d'anisotropie effectif supérieur ou égal à 500 mT.

## Patentansprüche

1. Verfahren zum Behandeln einer magnetischen Struktur (100), **dadurch gekennzeichnet, dass** es die folgenden Schritte aufweist:
- Bereitstellen (S10) einer magnetischen Struktur (100), die mindestens eine erste Schicht (102) aus magnetischem Material aufweist, das eine CoFeB-Legierung aufweist, wobei das magnetische Material auf ein Substrat (104) abgeschieden wird;
- Bestrahlen (S20) der magnetischen Struktur (100) durch niederenergetische leichte Ionen, die aus He+, H+, Ar+, Xe+ oder Ga+ ausgewählt werden, so dass die während des Schrittes des Bestrahlens emittierten Ionen durch die mindestens eine erste Schicht (102) aus magnetischem Material hindurchtreten und in einer Tiefe des Substrats zwischen 100 nm und 300 nm tief in das Substrat (104) implantiert werden und die Bestrahlung (S20) strukturelle Modifikationen der bestrahlten magnetischen Schichten verursacht; und
- gleichzeitiges Halten (S30) der magnetischen Struktur (100) gemäß einem vorbestimmten Temperaturprofil und für eine vorbestimmte Zeit.

2. Verfahren gemäß Anspruch 1, wobei die magnetische Struktur (100) mindestens eine zweite Schicht (106) eines Isolators in Kontakt mit der ersten Schicht (102) aus magnetischem Material aufweist, um einen Stapel (110) von Schichten (102, 106, 108) auszubilden, der direkt auf das Substrat (104) abgeschieden wird, wobei die während des Bestrahlungsschritts (S20) emittierten Ionen durch eine Maske (112) und den Stapel hindurchtreten und die Struktur in den magnetischen Schichten lokal modifizieren, wobei sie interatomare Verschiebungen bilden, bis sie tief in das Substrat (104) implantiert sind, auf dem der Stapel (110) von Schichten abgeschieden wurde.

3. Verfahren gemäß Anspruch 1 oder 2, wobei die vorbestimmte Temperatur zwischen 20°C und 200°C liegt.

4. Verfahren gemäß Anspruch 1 oder 2, wobei die vorbestimmte Temperatur zwischen 15°C und 40°C liegt.

5. Verfahren gemäß irgendeinem der Ansprüche 1 bis 4, wobei die vorbestimmte Zeit kleiner oder gleich 1 Stunde ist.

6. Verfahren gemäß irgendeinem der Ansprüche 1 bis 5, wobei das magnetische Material anfangs amorph ist.

7. Verfahren gemäß irgendeinem der Ansprüche 1 bis 5, wobei das magnetische Material anfangs kristallin ist.

8. Verfahren gemäß irgendeinem der Ansprüche 1 bis 7, wobei die Ionen He⁺-Ionen sind.

9. Verfahren gemäß irgendeinem der Ansprüche 1 bis 8, wobei die Ionen eine Energie zwischen 0,1 keV und 150 keV haben.

10. Verfahren gemäß irgendeinem der Ansprüche 1 bis 9, wobei beim Schritt des Bestrahlens (S20) die Ionen mit einer Dosis zwischen 1^{∗}10¹³ Ionen/cm² und 5^{∗}10¹⁶ Ionen/cm² emittiert werden.

11. Verfahren gemäß irgendeinem der Ansprüche 1 bis 10, wobei beim Schritt des Bestrahlens (S20) die Ionen die magnetische Struktur (100) durch Durchgangsöffnungen (114) einer Maske (112) hindurch bombardieren.

12. Verfahren gemäß irgendeinem der Ansprüche 1 bis 11, wobei die magnetische Struktur (100) einen abwechselnden Stapel aus ersten Schichten (102) aus magnetischem Material und zweiten Schichten (106) eines Isolators aufweist.

13. Magnetische Struktur (100), mindestens aufweisend:
- eine erste Schicht (102) aus magnetischem Material, das eine CoFeB-Legierung aufweist; und
- ein Substrat (104), auf dem die erste Schicht (102) aus magnetischem Material angeordnet ist;
**dadurch gekennzeichnet, dass** sie eine direkte Überlagerung zwischen dem Substrat (104) und der ersten Schicht (102) aufweist, die sich aus einer direkten Abscheidung des magnetischen Materials auf das Substrat (104) ergibt,
und dass das Substrat (104) niederenergetische leichte Atome aufweist, die in einer Tiefe zwischen 100 nm und 300 nm in das Substrat (104) implantiert sind.

14. Magnetische Struktur gemäß Anspruch 13, aufweisend ein effektives Anisotropiefeld von größer oder gleich 500 mT.

## Claims

1. Process for treating a magnetic structure (100), **characterized in that** it comprises the following steps:
- providing (S10) a magnetic structure (100) comprising at least one first layer (102) of magnetic material comprising a CoFeB alloy; said magnetic material being deposited on a substrate (104) ;
- irradiating (S20) the magnetic structure (100) with low-energy light ions chosen from He+, H+, Ar+, Xe+ ou Ga+, whereby the ions emitted during the irradiating step pass through the at least one first layer (102) of magnetic material and are implanted deep in ths substrate (104) at a depth in the substrate between 100 nm and 300 nm; and wherein said irradiating (S20) induces structural modifications of the irradiated magnetic layers
- simultaneously holding (S30) the magnetic structure (100) at a preset temperature profile and for a preset time.

2. Process according to claim 1, wherein the magnetic structure (100) comprises at least one second layer (106) of insulation in contact with the first layer (102) of magnetic material so as to form a stack (110) of layers (102, 106, 108) deposited directly on the substrate (104), the ions emitted during the irradiating step (S20) passing through a mask (112) and the stack and locally modifying the structure in the magnetic layers by creating inter-atomic displacements, until being implanted deep in the substrate (104) on which the stack (110) of layers has been deposited

3. Process according to claim 1 or 2, wherein the preset temperature is between 20°C and 200°C.

4. Process according to claim 1 or 2, wherein the preset temperature is between 15°C and 40°C.

5. Process according to any one of claims 1 to 4, wherein the preset time is less than or equal to 1 hour.

6. Process according to any one of claims 1 to 5, wherein the magnetic material is initially amorphous.

7. Process according to any one of claims 1 to 5, wherein the magnetic material is initially crystalline.

8. Process according to any one of claims 1 to 7, wherein the ions are He+ ions.

9. Process according to any one of claims 1 to 8, wherein the ions have an energy of between 0.1 keV and 150 keV.

10. Process according to any one of claims 1 to 9, wherein, during the irradiation step (S20), the ions are emitted at a dose of between 1^{∗}10¹³ ions/cm² and 5^{∗}10¹⁶ ions/cm².

11. Process according to any one of claims 1 to 10, wherein, during the irradiation step (S20), the ions bombard the magnetic structure (100) via through-openings (114) in a mask (112).

12. Process according to any one of claims 1 to 11, wherein the magnetic structure (100) comprises a stack of alternating first layers (102) of magnetic material and second layers (106) of insulation.

13. Magnetic structure (100), comprising at least:
- a first layer (102) of magnetic material comprising a CoFeB alloy; and
- a substrate (104) on which is arranged the first layer (102) of magnetic material ; **characterized in that** it comprises a direct superposition between the substrate (104) and the first layer (102), resulting from a direct deposition of said magnetic material on the substrate (104), and **in that** the substrate (104) comprises low-energy light atoms, implanted in the substrate (104) at a depth between 100 nm and 300 nm.

14. Magnetic structure (100) according to claim 13, having an effective anisotropic field that is greater than or equal to 500 mT.
